Europäisches Patentamt

European Patent Office

Office européen des brevets

(19)

(11) Publication number: **0 263 547 B1**

(12) **EUROPEAN PATENT SPECIFICATION**

(45) Date of publication of patent specification: **27.05.92**    (51) Int. Cl.⁵: **G11C 7/06**

(21) Application number: **87201708.2**

(22) Date of filing: **09.09.87**

(54) **Semiconductor memory circuit having a fast read amplifier tristate bus driver.**

(30) Priority: **11.09.86 NL 8602295**

(43) Date of publication of application:
**13.04.88 Bulletin 88/15**

(45) Publication of the grant of the patent:
**27.05.92 Bulletin 92/22**

(84) Designated Contracting States:
**DE FR GB IT**

(56) References cited:
**EP-A- 0 130 910**

**IBM TECHNICAL DISCLOSURE BULLETIN, vol.
16, no. 12, May 1974, pages 3960-3961, New
York, US; J. GSCHWENDTNER et al.: "Sense
system"**

**IEEE INTERNATIONAL SOLID-STATE CIR-
CUITS CONFERENCE, San Francisco,
22nd-24th February 1984, vol. 27, conference
31, pages 214-215, IEEE, New York, US; M.
ISOBE et al.: "A 46ns 256K CMOS RAM"**

(73) Proprietor: **N.V. Philips' Gloeilampenfabrieken
Groenewoudseweg 1
NL-5621 BA Eindhoven(NL)**

(72) Inventor: **Hartgring, Cornelis Dietwin
c/o INT. OCTROOIBUREAU B.V. Prof. Holst-
laan 6
NL-5656 AA Eindhoven(NL)**

(74) Representative: **Faessen, Louis Marie Huber-
tus et al
INTERNATIONAAL OCTROOIBUREAU B.V.
Prof. Holstlaan 6
NL-5656 AA Eindhoven(NL)**

Rank Xerox (UK) Business Services

## Description

The invention relates to a CMOS semiconductor memory circuit, having memory cells (M) with a selectable connection to a read amplifier (SA), the read amplifier feeding a tristate data bus driver (TSD) which has a push-pull output stage comprising a first (P5) and a second (N5) output transistor with their channels in serial arrangement, the memory circuit having control means (DEQ) for making the first and second output transistors simultaneously non-conductive in order to bring the output (O2) of the output stage in a high impedance state.

Such a semiconductor memory circuit is known from the conference ISSCC 1984, February 23, pp. 214-215 and 340, in which it was stated already that delay times occuring in word and bit lines and also in read amplifiers and bus drivers are of vital importance for memory circuits of large capacity (for example, 256 k bit). A small dissipated power and compact buffers in a memory of comparatively large capacity are also of importance.

It is the object of the invention to provide a tristate buffer which is compact.

A semiconductor memory circuit according to the invention is characterized in that the read amplifier feeds the output stage via an inverting AND circuit (N41, N42, P41, P43), the read amplifier being coupled to a first input of the AND circuit formed by respective connected gates of a first (N41) and a second (P41) AND transistor, the AND circuit also having a second input formed by further respective connected gates of a third (N42) and fourth (P42) AND transistors, respective channels of the second (P41) and fourth (P42) AND transistors being connected in a parallel arrangement, which is connected in series with successively the further channnels of the third (N42) and first (N41) AND transistors, a first node between the parallel arrangement (P41, P42) and the third AND transistor (N42) being coupled to a gate of the first output transistor (P5), a second node between the channels of the first (N41) and third (N42) AND transistors being coupled to the second output transistor (N5), wherein the first output transistor (P5), the second (P41) and fourth (P42) AND transistor are all of a first transistor type, being either NMOS or PMOS, and the second output transistor (N5), the first (N41) and third (N42) AND transistors are all of a second transistor type, different form the first transistor type and wherein the control means (DEC are arranged for in the high impedance state of said output (O2) controlling the first and second input such that the first AND transistor (N41) and the fourth AND transistor become conductive (P42).

The use of such a tristate buffer is compact and is active only if the control means do not make both the first and fourth AND transistors conductive which need be only of a very short duration (for example, during the active state of the read amplifier or ony at the end of the active period thereof).

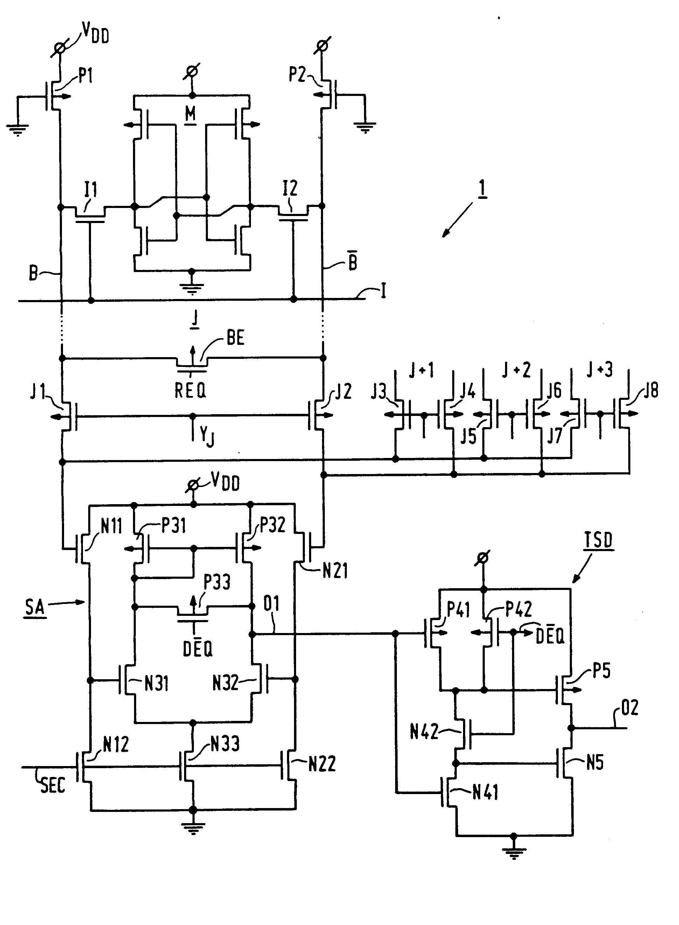

The invention will be described in greater detail with reference to an embodiment shown in the drawing. The drawing shows a simplification of a memory circuit 1 according to the invention. The memory circuit 1 comprises memory cells which are arranged in columns and rows and of which only one cell M in a column J is shown in the drawing. The memory cell M is a C-MOS cell which is known per se and which is connected to the two bit lines $\overline{B}$ and $\overline{B}$ via two pass transistors I1 and I2. The two pass transistors I1 and I2 are controlled via the word line I for accessing the cell M for a read or write action. The two bit lines B and $\overline{B}$ are each connected, via pull up transistors P1 and P2, respectively, to a supply point VDD. An equalising transistor BE is connected between the bit lines B and $\overline{B}$ and is made conductive for a moment by means of an equalisation signal REQ before a memory cell M in said column is connected to the bit lines B and $\overline{B}$. Via two pass transistors J1 and J2, which are controlled by means of a column selection signal YJ, the two bit lines B and $\overline{B}$ are connected to the read amplifier SA. Via the transistors J3, J4 or J5, J6 or J7, J8, the two bit lines of the columns J+1 or J+2 or J+3 can be connected to the read amplifier SA.

The read amplifier SA comprises three amplifiers; a first and a second follower amplifier and a difference amplifier. The first and the second follower amplifiers, respectively, comprise the transistors N11, N12 and N21, N22, respectively. The difference amplifier comprises three P-MOS transistors P31, P32 and P33 and three N-MOS transistors N31, N32 and N33. By using the pull-up transistors P1 and P2 the logic "high" voltage approaches approximately the supply voltage VDD, while the logic low level is set approximately 1 Volt below VDD. In order to bring voltage levels of the logic high and logic low signals on the bit lines B and $\overline{B}$ at the level which is most senstive for the difference amplifier with the input transistors N31 and N32, the two d.c.-shifting follower amplifiers are used with the transistors N11, N12 and N21, N22. The three amplifiers are activated with a selection signal SEC which is supplied to three transistors N12, N22 and N32. The selection signal SEC activates the three amplifiers only for a comparatively short period of time. It is hence permitted, due to gain in velocity, to permit a comparatively high dissipation in the amplifiers. As long as the selection signal SEC is not active, an equalisation signal DEQ which is applied to the transistor P33 can keep said transistor turned on for equalising the voltage levels in the two amplifier branches with the transistors P31, N31 and P32, N32.

An output 01 of the read amplifier SA is applied to an output of a C-MOS inverting AND gate of a tristate driver TSD. The inverting AND gate comprises the P-MOS transistors P41, P42 and the N-MOS transistors N41, N42 and further receives the equalisation signal DEQ. The output of the inverting AND gate is connected to the gate electrode of P-MOS transistors P5 of the push pull output stage of the tristate bus driver TSD. The N-MOS transistor N5 of the output stage is connected to the junction between the N-MOS transistors N41 and N42. The output 0 2 is connected to an internal read bus of the memory which via a latch circuit known per se is applied to an output buffer. It will be recognized that as long as the equalisation signal DEQ is low, the transistor P42 is turned on and the transistors P5 and N42 are turned off. The N-MOS transistor N41 will further be blocking N-MOS transistor N5 or will be blocking this transistor due to a signal received via output 01 of the read amplifier SA in which the equalisation signal DEQ turns on the transistor P33 and in which the transistors N12, N22 and N33 will be turned off again. The output of the bus driver TSD is now floating (has a high output impedance).

## Claims

1. CMOS semiconductor memory circuit, having memory cells (M) with a selectable connection to a read amplifier (SA), the read amplifier feeding a tristate data bus driver (TSD) which has a push-pull output stage comprising a first (P5) and a second (N5) output transistor with their channels in serial arrangement, the memory circuit having control means (DEQ) for making the first and second output transistors simultaneously non-conductive in order to bring the output (O2) of the output stage in a high impedance state, characterized, in that the read amplifier feeds the output stage via a inverting AND circuit (N41, N42, P41, P43), the read amplifier being coupled to a first input of the AND circuit formed by respective connected gates of a first (N41) and a second (P41) AND transistor, the AND circuit also having a second input formed by further respective connected gates of a third (N42) and fourth (P42) AND transistors, respective channels of the second (P41) and fourth (P42) AND transistors being connected in a parallel arrangement, which is connected in series with successively the further channels of the third (N42) and first (N41) AND transistors, a first node between the parallel arrangement (P41, P42) and the third AND transistor (N42) being coupled to a gate of the first output transistor (P5), a second node between the channels of the first (N41) and third (N42) AND transistors being coupled to the second output transistor (N5), wherein the first output transistor (P5), the second (P41) ad fourth (P42) AND transistor are all of a first transistor type, being either NMOS or PMOS, and the second output transistor (N5), the first (N41) and third (N42) AND transistors are all of a second transistor type, different form the first transistor type, and wherein the control means (DEQ) are arranged for in the high impedance state of said output (O2) controlling the first and second input such that the first AND transistor (N41) and the fourth AND transistor (P42) become conductive.

2. A CMOS semiconductor memory circuit according to Claim 1, characterized, in that control means (DEQ) in the high impedance state of said output (O2) make a levelling transistor (P33) in the read amplifier conductive.

## Revendications

1. Circuit mémoire à semi-conducteur CMOS, comportant des cellules de mémoire (M) avec une connexion sélectionnable à un amplificateur de lecture (SA), l'amplificateur de lecture alimentant un circuit de commande à trois états (TSD) qui comporte un étage de sortie push-pull comprenant un premier transistor de sortie (P5) et un second transistor de sortie (N5) dont les canaux sont en série, le circuit mémoire comportant des moyens de commande (DEQ) pour rendre le premier et le second transistor de sortie simultanément non conducteurs en vue d'amener la sortie (O2) de l'étage de sortie dans un état de haute impédance, caractérisé en ce que l'amplificateur de lecture alimente l'étage de sortie par l'intermédiaire d'un circuit ET inverseur (N41, N42, P41, P42), l'amplificateur de lecture étant couplé à une première entrée du circuit ET formée par des portes connectées respectives d'un premier transistor ET (N41) et d'un deuxième transistor ET (P41), le circuit ET comportant également une seconde entrée formée par d'autres portes connectées respectives d'un troisième transistor ET (N42) et d'un quatrième transistor ET (P42), des canaux respectifs du deuxième transistor ET (P41) et du quatrième transistor ET (P42) état connectés en un montage en parallèle qui est connecté a série, avec, successivement, les autres canaux du troisième transistor ET (N42) et du premier transistor ET (N41), un premier noeud entre le montage en parallèle (P41, P42) et le troisième transistor ET (N42) état couplé à une porte du premier transistor de sortie (P5), un second noeud entre les canaux du premier transistor ET (N41) et du troisième transistor ET (N42) état couplé au second transistor de sortie (N5), état entendu que le premier transistor de sortie (P5), le deuxième transistor ET (P41) et le quatrième transistor ET (P42) sont tous d'un premier type de transistor, soit NMOS, soit PMOS, et que le deuxième transistor de sortie (N5), le premier transistor ET (N41) et le troisième transistor ET (N42) sont tous d'un second type de transistor, différent du premier type de transistor, alors que les moyens de commande (DEQ) sont prévus pour, dans l'état de haute impédance de la sortie (O2), commander la première et la deuxième entrée de telle façon que le premier transistor ET (N41) et le quatrième transistor ET (P42) deviennent conducteurs.

2. Circuit mémoire à semi-conducteur CMOS suivant la revendication 1, caractérisé en ce que des moyens de commande (DEQ) dans l'état de haute impédance de la sortie (O2) rendent conducteur un transistor d'égalisation (P33) dans l'amplificateur de lecture.

**Patentansprüche**

1. CMOS-Halbleiterschaltung mit Speicherzellen (M) mit einem wählbaren Anschluß an einen Leseverstärker (SA), wobei der Leseverstärker einen Tristate-Datenbustreiber (TSD) versorgt, der eine Gegentaktendstufe mit einem ersten (P5) und einem zweiten (N5) Ausgangstransistor hat, deren Kanäle in Reihe geschaltet sind, wobei die Speicherschaltung Steuerungsmittel (DEQ) hat, um die ersten und zweiten Ausgangstransistoren gleichzeitig nicht-leitend zu machen, damit der Ausgag (O2) der Endstufe in einen hohen Impedanzzustand gebracht wird, dadurch gekennzeichnet, daß der Leseverstärker die Endstufe über eine invertierende UND-Schaltung ((N41, N42, P41, P43) versorgt, wobei der Leseverstärker an einen ersten Eingang der aus verbundenen Gates eines ersten (N41) bzw. eines zweiten (P41) UND-Transistors gebildeten UND-Schaltung, gekoppelt ist, welche UND-Schaltung auch einen zweiten Eingang hat, der aus weiteren verbundenen Gates eines dritten (N42) bzw. vierten (P42) UND-Transistors gebildet wird, wobei Kanäle des zweiten (P41) bzw. vierten (P42) UND-Transistors in einer Parallelschaltung verbunden sind, die aufeinanderfolgend mit den weiteren Kanälen des dritten (N42) und ersten (N41) UND-Transistors in Reihe geschaltet sind, wobei ein erster Knoten zwischen der Parallelschaltung (P41,P42) und dem dritten UND-Transistor (N42) mit einem Gate des ersten Ausgangstransistors (P5) verbunden ist, ein zweiter Knoten zwischen den Kanälen des ersten (N41) und dritten (N42) UND-Transistors mit dem zweiten Ausgangstransistor (N5) verbunden ist, worin der erste Ausgangstransistor (P5), der zweite (P41) und vierte (P42) UND-Transistor alle von einem ersten Transistortyp, entweder NMOS oder PMOS, sind, und der zweite Ausgagstransistor (N5), der erste (N41) und dritte (N42) UND-Transistor alle von einem zweiten Transistortyp sind, der nicht der erste Transistortyp ist, und worin die Steuerungsmittel (DEQ) so angeordnet sind, daß sie im hohen Impedanzzustand des genannten Ausgangs (O2) den ersten und zweiten Eingang so steuern, daß der erste UND-Transistor (N41) und der vierte UND-Transistor (P42) leitend werden.

2. CMOS-Halbleiterschaltung nach Anspruch 1, dadurch gekennzeichnet, daß Steuerungsmittel (DEQ) im hohen Impedanzzustand des genannten Ausgangs (O2) einen Ausgleichstransistor (P33) in dem Leseverstärker leitend machen.